# EUROPEAN PATENT APPLICATION

(11) **EP 3 819 397 A1**
(43) Date of publication of application: **12.05.2021**
(21) Application number: 20203894.9
(22) Date of filing: 26.10.2020
(51) Int. Cl.: C23C 18/18, C23C 18/40, H05K 3/24

(54) **ELECTROLESS COPPER PLATING AND COUNTERACTING PASSIVATION**

(30) Priority: 11.11.2019 US 201916679373
(71) Applicant: Rohm and Haas Electronic Materials LLC, Marlborough, MA 01752 (US)
(72) Inventor: NAAB, Benjamin, Marlborough, MA Massachusetts 01752 (US)
(74) Representative: Houghton, Mark Phillip

(57) **Abstract**

Prior to electroless copper plating on substrates containing copper, an aqueous composition containing select imidazole compounds is applied to the substrate. The aqueous composition containing the select imidazole compounds counteract passivation of the copper on the substrate to improve the electroless copper plating process.

## Description

### Field of the Invention

The present invention is directed to methods of electroless copper plating and methods to counteract the effects of passivation of copper on copper containing substrates. More specifically, the present invention is directed to methods of electroless copper plating and methods to counteract the effects of passivation of copper on copper containing substrates with aqueous compositions containing select imidazole compounds.

### Background of the Invention

Electroless copper plating is in widespread use in metallization industries for depositing copper on various types of substrates. In the manufacture of printed circuit boards, for example, electroless copper baths are used to deposit copper on walls of through-holes and on circuit paths as a base for subsequent electrolytic copper plating. Electroless copper plating also is used in the decorative plastics industry for deposition of copper on non-conductive surfaces as a base for further plating of copper, nickel, gold, silver and other metals, as required. Electroless copper baths which are in commercial use today contain water soluble divalent copper compounds, chelating agents or complexing agents, for example, Rochelle salts (potassium sodium tartrate tetrahydrate) and sodium salts of ethylenediamine tetraacetic acid, for the divalent copper ions, reducing agents, for example, formaldehyde, and formaldehyde precursors or derivatives, and various addition agents to make the bath more stable, adjust the plating rate and brighten the copper deposit.

A problem observed at startup, especially with tartaric-based electroless copper plating, is the oxidation or passivation of substrates such as copper clad laminates that results from inadequate initiation of electroless copper plating. One form of copper passivation is the formation of microcoatings of copper oxides on the surface of metallic copper, such as cuprous oxide (Cu₂O) and cupric oxide (CuO). While passivation can be a desirable method for preventing corrosion of copper, in electroless copper plating the presence of oxidation on the copper surface can inhibit the desirable catalytic activity of the copper surface. This problem is most commonly observed with tartaric acid-based electroless copper plating baths, and can manifest as a range of surface coloration on copper clad laminates at start-up. This oxidation phenomena observed on the copper surface can also impact the copper pad at via bottoms and inner-layer copper surfaces thereby compromising the reliability of interconnections.

To address the problem, a conventional approach is to apply a strike voltage to the copper containing substrate. The strike roller provides a reducing potential to the panel surface that electrolytically reduces the surface passivation on the copper surface and deposits a thin copper seed layer that is active toward electroless copper plating. However, a strike voltage has the potential to be ineffective if the panel is too small to span the distance from the cathode roller to the electroless bath, or if the circuit design does not permit connection of all copper surfaces to the strike roller and electroless bath at the same time. In such cases there is risk that not all copper surfaces react to the effect of the strike roller, and as such, some surfaces may not properly initiate electroless copper. The strike rollers are arranged before the electroless bath, but are not themselves immersed in electroless solution (or plating would occur on the roller). The strike voltage takes effect when the panel spans the distance between the strike roller and the electroless bath solution. If the panel is too small to span this distance then the strike will have no effect. Such situations necessarily require alternative methods of addressing the passivation problem.

Therefore, there is a need for a method of electroless copper plating and methods to counteract the effects of passivation of copper containing substrates.

### Summary of the Invention

The present invention is directed to a method of electroless copper plating including:
a) providing a substrate comprising copper;
b) applying a catalyst to the copper of the substrate;
c) treating the catalyzed copper of the substrate with an aqueous composition comprising an imidazole compound, wherein the imidazole compound has the formula: 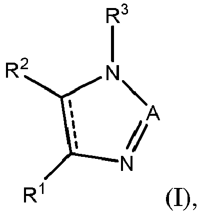 wherein R¹ and R² are independently chosen from hydrogen, (C₁-C₄)alkyl and an ester group or the carbons of R¹ and R² can be taken together to form a substituted or unsubstituted fused six membered carbon aromatic ring, wherein the substituent groups on the six membered carbon aromatic ring are selected from the group consisting of carboxyl, carboxy(C₁-C₄)alkyl, hydroxyl, hydroxy(C₁-C₄)alkyl, amino and amino(C₁-C₄)alkyl, R³ is hydrogen, hydroxyl, hydroxy(C₁-C₄)alkyl, amino or amino(C₁-C₄)alkyl, and A can be a nitrogen atom or a carbon atom, wherein when A is a carbon atom, the carbon atom can have a substituent group selected from the group consisting of substituted or unsubstituted imidazole, guanidino, substituted phenyl, amino(C₁-C₄)alkyl, and naphthyl(C₁-C₄)alkyl;
d) applying an electroless copper plating bath to the treated copper of the substrate; and
e) electroless plating copper on the treated copper of the substrate with the electroless copper plating bath.

The present invention is also directed to a method of electroless copper plating including:
a) providing a substrate comprising copper;
b) applying a catalyst to the copper of the substrate;
c) treating the catalyzed copper of the substrate with an aqueous composition comprising a reducing agent and an imidazole compound, wherein the imidazole compound has the formula: 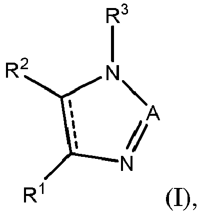 wherein R¹ and R² are independently chosen from hydrogen, (C₁-C₄)alkyl and an ester group or the carbons of R¹ and R² can be taken together to form a substituted or unsubstituted fused six membered carbon aromatic ring, wherein the substituent groups on the six membered carbon aromatic ring are selected from the group consisting of carboxyl, carboxy(C₁-C₄)alkyl, hydroxyl, hydroxy(C₁-C₄)alkyl, amino and amino(C₁-C₄)alkyl, R³ is hydrogen, hydroxyl, hydroxy(C₁-C₄)alkyl, amino or amino(C₁-C₄)alkyl, and A can be a nitrogen atom or a carbon atom, wherein when A is a carbon atom, the carbon atom can have a substituent group selected from the group consisting of substituted or unsubstituted imidazole, guanidino, substituted phenyl, amino(C₁-C₄)alkyl, naphthyl(C₁-C₄)alkyl;
d) applying an electroless copper plating bath to the treated copper of the substrate; and
e) electroless plating copper on the treated copper of the substrate with the electroless copper plating bath.

The present invention is further directed to a method of electroless copper plating including:
a) providing a substrate comprising copper;
b) applying a catalyst to the copper of the substrate;
c) applying a reducing agent to the catalyzed copper of the substrate;
d) treating the catalyzed copper of the substrate with an aqueous composition comprising an imidazole compound, wherein the imidazole compound has the formula: 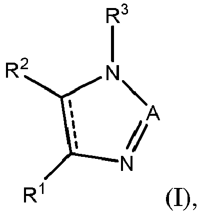 wherein R¹ and R² are independently chosen from hydrogen, (C₁-C₄)alkyl and an ester group or the carbons of R¹ and R² can be taken together to form a substituted or unsubstituted fused six membered carbon aromatic ring, wherein the substituent groups on the six membered carbon aromatic ring are selected from the group consisting of carboxyl, carboxy(C₁-C₄)alkyl, hydroxyl, hydroxy(C₁-C₄)alkyl, amino and amino(C₁-C₄)alkyl, R³ is hydrogen, hydroxyl, hydroxy(C₁-C₄)alkyl, amino or amino(C₁-C₄)alkyl, and A can be a nitrogen atom or a carbon atom, wherein when A is a carbon atom, the carbon atom can have a substituent group selected from the group consisting of substituted or unsubstituted imidazole, guanidino, substituted phenyl, amino(C₁-C₄)alkyl, and naphthyl(C₁-C₄)alkyl;
e) applying an electroless copper plating bath to the treated copper of the substrate; and
f) electroless plating copper on the treated copper of the substrate with the electroless copper plating bath.

The methods of the present invention counteract the effects of passivation of copper on substrates and enable initiation of electroless copper plating on the copper of the substrates. The methods of the present invention also enable rapid initiation of electroless copper plating on the copper of the substrates.

### Brief Description of the Drawing

**Figure 1** is an open-circuit graph of potential in volts vs. time in seconds showing no initiation of electroless copper plating.
**Figure 2** is an open-circuit graph of potential in volts vs. time in seconds showing fast initiation of electroless copper plating.
**Figure 3** is chronopotentiometry graph of potential in volts vs. time in seconds showing a short period of time for reducing copper oxide.
**Figure 4** is chronopotentiometry graph of potential in volts vs. time in seconds showing long periods of time for reducing copper oxide.

### Detailed Description of the Invention

As used throughout this specification, the abbreviations given below have the following meanings, unless the context clearly indicates otherwise: g = gram; mg = milligram; mL = milliliter; L = liter; cm = centimeter; m = meter; mm = millimeter; µm = micron; ppm = parts per million = mg/L; sec = second; min. = minute; ° C = degrees Centigrade; mA = milliamperes; V = volts; g/L = grams per liter; DI = deionized; Pd = palladium; Pd(II) = palladium ions with a +2 oxidation state; Pd° = palladium reduced to its metal unionized state; Ag = silver; Cl = chloride; K = potassium; Li = lithium; wt% = percent by weight; Vol.% = volume percent; and e.g. = example.

The terms "plating" and "deposition" are used interchangeably throughout this specification. The terms "composition" and "bath" are used interchangeably throughout this specification. The term "passivation" means oxidation, such as formation of cuprous and cupric oxide on copper metal surfaces. The term "anti-passivation" means to counteract the effects of oxidation. The term "counteract" means to act against something to reduce its force or neutralize it. The term "open circuit potential" or "open circuit voltage" means the difference of electrical potential between two terminals of a device when disconnected from any circuit (no external load connected or no external electric current flows between terminals). The term "chronopotentiometry" means an electrochemical technique in which the potential of the working electrode is monitored as a function of time while a constant reducing current is applied to the panel surface; current goes first to the most positive reduction pathway, and as the reactants for each pathway are consumed the current is driven to the next most favorable reaction resulting in a series of potential steps. The "--------" in a chemical structure represents an optional chemical bond. The term "amino" means a chemical moiety having the formula: - NR'R", wherein R' and R" can be the same or different and are selected from the groups consisting of hydrogen and (C₁-C₄)alkyl group. The abbreviation "ca" means approximately. All amounts are percent by weight, unless otherwise noted. All numerical ranges are inclusive and combinable in any order except where it is logical that such numerical ranges are constrained to add up to 100%.

Prior to electroless copper plating of copper metal on substrates, the copper metal of the substrates is treated with aqueous solutions of anti-passivation compounds to counteract the effects of oxidation of the copper of the substrates to enable initiation of electroless copper plating, preferably, rapid initiation of electroless copper plating. While not being bound by theory, the anti-passivation compounds counteract the passivation by either solubilizing the passivation of the copper that inhibits electroless copper plating or, in the alternative, the anti-passivation compounds counteract the passivation by forming an active molecular complex on the copper surface to initiate electroless copper plating.

The anti-passivation compounds of the present invention are imidazole compounds, wherein the imidazole compounds have the formula: 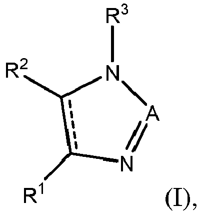 wherein R¹ and R² are independently chosen from hydrogen, (C₁-C₄)alkyl and an ester group, or the carbons of R¹ and R² can be taken together to form a substituted or unsubstituted six membered carbon aromatic fused ring, wherein the substituent groups on the six membered carbon aromatic fused ring are selected from the group consisting of carboxyl, carboxy(C₁-C₄)alkyl, hydroxyl, hydroxy(C₁-C₄)alkyl, amino and amino(Ci-C₄)alkyl, R³ is hydrogen, hydroxyl, hydroxy(C₁-C₄)alkyl, amino or amino(C₁-C₄)alkyl, and A can be a nitrogen atom or a carbon atom, wherein when A is a carbon atom, the carbon atom can have a substituent group selected from the group consisting of substituted or unsubstituted imidazole, guanidino, substituted phenyl, amino(C₁-C₄)alkyl, and naphthyl(C₁-C₄)alkyl, wherein the substituent groups on the phenyl include, but are not limited to, hydroxyl, hydroxy(C₁-C₄)alkyl, amino, or amino(C₁-C₄)alkyl, and the substituent groups on the imidazole include, but are not limited to, (C₁-C₄)alkyl, hydroxyl, hydoxy(C₁-C₄)alkyl, amino, amino(C₁-C₄)alkyl, carboxyl, carboxy(C₁-C₄)alkyl or an ester group.

Preferably, the imidazole compound has the formula: 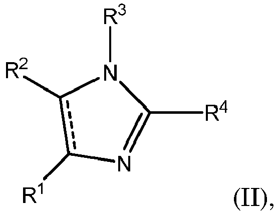 wherein R¹ and R² are independently hydrogen, (C₁-C₃)alkyl, and an ester group, or R¹ and R² are taken together with all of their carbon atoms to form a substituted or unsubstituted six membered carbon aromatic fused ring, wherein the substituent groups on the six membered carbon aromatic fused ring are selected from the group consisting of carboxyl, carboxy(C₁-C₃)alkyl, hydroxyl, hydroxy(C₁-C₃)alkyl, amino and amino(Ci-C₃)alkyl, R³ is hydrogen or amino(C₁-C₂)alkyl, and R⁴ is selected from the group consisting of substituted or unsubstituted imidazole, guanidino, substituted phenyl, amino(C₁-C₄)alkyl, and naphthyl(C₁-C₄)alkyl, wherein the substituent groups on the phenyl are selected from the group consisting of hydroxyl and amino and the substituent groups on the imidazole are selected from the group consisting of (C₁-C₃)alkyl, hydroxyl(C₁-C₃)alkyl and amino(C₁-C₃)alkyl; more preferably, R¹ and R² are independently hydrogen, (C₁-C₂)alkyl, or R¹ and R² are taken together with all of their carbon atoms to form an unsubstituted six membered carbon aromatic fused ring, R³ is hydrogen, and R⁴ is selected from the group consisting of substituted imidazole, guanidino, amino(C₁-C₂)alkyl and substituted phenyl, wherein the substituent groups on the imidazole are (C₁-C₂)alkyl, and the substituent groups on the phenyl are selected from the group consisting of hydroxyl and amino, wherein the amino group is -NH₂; most preferably, R¹ and R² are (C₁-C₂)alkyl, R³ is hydrogen, and R⁴ is substituted imidazole, wherein the substituent groups are (C₁-C₂)alkyl or, in the alternative, R¹ and R² are taken together with their carbon atoms to form an unsubstituted six membered carbon aromatic fused ring, R³ is hydrogen, and R⁴ is guanidino.

Exemplary anti-passivation compounds of the present invention are the following compounds:
2,2'-bis(4,5-dimethylimidazole) having the formula: 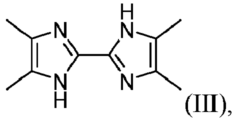
2-guanidobenzimidaole having the formula: 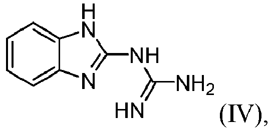
2-(aminomethyl)benzimidazole dihydrochloride having the formula: 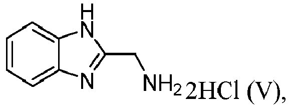
1-(3-aminopropyl)imidazole having the formula: 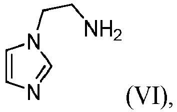
2-(1-naphthylmethyl)imidazoline hydrochloride having the formula: 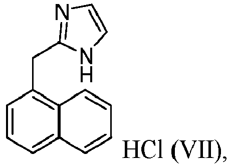
2-(2-aminophenyl)-1H-benzimidazole having the formula: 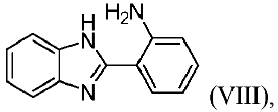
2-(2-hydroxyphenyl)-1H-benzamidozole having the formula: 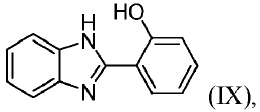
Benzotriazole-5-carboxylic acid having the formula: 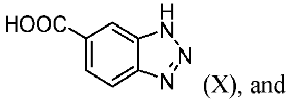
Dimethyl-4,5-imidazoledicarboxylate having the formula:

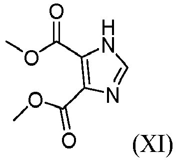

The anti-passivation compounds can be included in an aqueous reducing solution which reduces metal ions of an ionic catalyst to the metallic state or, in the alternative, the anti-passivation compounds can be included in an aqueous rinse applied following the application of the aqueous reducing solution to the catalyzed substrate. The anti-passivation compounds can also be included in both the aqueous reducing solution and in the aqueous rinse which follows the application of the reducing solution to the catalyzed substrate during the same electroless copper plating method. Mixtures of the anti-passivation compounds can also be included in the reducing solution or in the aqueous rinse of the present invention. Preferably, the anti-passivation compounds are included in amounts of 0.1 mg/L to 100 mg/L, more preferably, from 0.5 mg/L to 50 mg/L, further preferably, from 0.5 mg/L to 10 mg/L.

The water contained in the aqueous reducing solutions and aqueous rinse solutions used in the method of the present invention is preferably at least one of deionized and distilled to limit incidental impurities.

In one embodiment, the aqueous reducing solutions include one or more reducing agents in addition to one or more anti-passivation compounds. Reducing agents include, but are not limited to, formaldehyde, formaldehyde precursors, formaldehyde derivatives, such as paraformaldehyde, borohydrides, such sodium borohydride, substituted borohydrides, boranes, such as dimethylamine borane (DMAB), ascorbic acid, isoascorbic acid, hypophosphite or salts thereof, such as sodium hypophosphite, hydroquinone, catechol, resorcinol, quinol, pyrogallol, hydroxyquinol, phloroglucinol, guaiacol, gallic acid, 3,4-dihydroxybenzoic acid, phenolsulfonic acid, cresolsulfonic acid, hydroquinonsulfonic acid, ceatecholsulfonic acid, or salts of all of the foregoing reducing agents. Preferably, the reducing agents are chosen from formaldehyde, formaldehyde derivatives, formaldehyde precursors, borohydrides, dimethylamine borane (DMAB), hypophosphite or salts thereof, hydroquinone, catechol, resorcinol, or gallic acid. More preferably, the reducing agents are chosen from dimethylamine borane (DMAB), formaldehyde, formaldehyde derivatives, formaldehyde precursors, or sodium hypophosphite. Most preferably, the reducing agent is dimethylamine borane (DMAB).

Reducing agents are included in the reducing solutions in amounts sufficient to reduce all the metal ions of the catalyst to their metallic state. Preferably, reducing agents are included in amounts of 0.1 g/L to 100 g/L, more preferably, from 0.1 g/L to 60 g/L, even more preferably, from 0.1 g/L to 10 g/L, further preferably, from 0.1 g/L to 5 g/L, most preferably, from 0.1 g/L to 2 g/L.

Optionally, one or more acids can be included in the reducing solution. Such acids include, but are not limited to boric acid, acetic acid, citric acid, hydrochloric acid, sulfuric acid, sulfamic acid, phosphoric acid or alkane sulfonic acids. Such acids can be included in the aqueous reducing solution in amounts of 0.5 g/L or greater, preferably, from 0.5 g/L to 20 g/l, more preferably, from 1 g/L to 10 g/L.

The pH of the aqueous reducing solution ranges from less than 1 to 14, preferably, from 1 to 12, more preferably, from 2 to 10, further preferably, from 6 to 8, most preferably, from 7 to 7.5.

Preferably, the aqueous reducing solutions of the present invention consist of water, one or more anti-passivation compounds, one or more reducing agents and optionally one or more acids. More preferably, the aqueous reducing solutions of the present invention consist of water, one or more anti-passivation compounds, one or more reducing agents and one or more acids.

In another embodiment, when the anti-passivation compounds are included in the aqueous rinse following application of the reducing solution to the catalyzed substrate, the aqueous rinse consists of water and one or more of the anti-passivation compounds. The anti-passivation compounds are preferably included in the rinse in amounts of 0.1 mg/L to 100 mg/L, more preferably, from 0.5 mg/L to 50 mg/L, further preferably, from 0.5 mg/L to 10 mg/L.

The methods and compositions of the present invention can be used to electroless plate copper on various substrates such as semiconductors, metal-clad and unclad substrates such as printed circuit boards. Such metal-clad and unclad printed circuit boards can include thermosetting resins, thermoplastic resins and combinations thereof, including fibers, such as fiberglass, and impregnated embodiments of the foregoing. Preferably, the substrate is a metal-clad epoxy containing printed circuit or wiring board with a plurality of features, such as through-holes, vias or combinations thereof. The compositions and methods of the present invention can be used in both horizontal and vertical processes of manufacturing printed circuit boards, preferably, the compositions and methods of the present invention are used in horizontal processes.

Preferably, the substrates to be electroless copper plated with the compositions and methods of the present invention are metal-clad substrates with dielectric material, such as epoxy or epoxy in combination with other conventional resin material and a plurality of features such as through-holes or vias or combinations of through-holes and vias, such as printed circuit boards. Optionally, the boards are rinsed with water and cleaned and degreased followed by desmearing the through-hole or via walls. Prepping or softening the dielectric or desmearing of the through-holes or vias can begin with application of a solvent swell.

In the methods of the present invention, optionally, the substrates are cleaned or degreased with conventional cleaning and degreasing compositions and methods. Optionally, a solvent swell is applied to the substrates, through-holes or vias of the substrates are desmeared, and various aqueous rinses can, optionally, be applied under conventional conditions and amounts well known to those of ordinary skill in the art.

Conventional solvent swells can be used. The specific type can vary depending on the type of dielectric material. Minor experimentation can be done to determine which solvent swell is suitable for a specific dielectric material. Solvent swells include, but are not limited to, glycol ethers and their associated ether acetates. Conventional amounts of glycol ethers and their associated ether acetates are well known to those of skill in the art. Examples of commercially available solvent swells are CIRCUPOSIT™ MLB Conditioner 211, CIRCUPOSIT™ Conditioner 3302A, CIRCUPOSIT™ Hole Prep 3303 and CIRCUPOSIT™ Hole Prep 4120 solutions (available from DuPont™, Wilmington, DE, USA).

After the solvent swell, optionally, a promoter can be applied. Conventional promoters can be used. Such promoters include sulfuric acid, chromic acid, alkaline permanganate or plasma etching. Preferably, alkaline permanganate is used as the promoter. Examples of commercially available promoters are CIRCUPOSIT™ Promoter 4130 and CIRCUPOSIT™ MLB Promoter 3308 solutions (available from DuPont™, Wilmington, DE, USA). Solvent swells are applied under conventional parameters and amounts well known to those of ordinary skill in the art. Optionally, the substrate is rinsed with water.

If a promoter is applied, a neutralizer is then applied to neutralize any residues left by the promoter. Conventional neutralizers can be used. Preferably, the neutralizer is an aqueous acidic solution containing one or more amines or a solution of 3wt% hydrogen peroxide and 3wt% sulfuric acid. Examples of commercially available neutralizers are CIRCUPOSIT™ MLB Neutralizer 216-5 and CIRCUPOSIT™ MLB Neutralizer 216-3 (available from DuPont™). Promoters are applied under conventional conditions and amounts well known to those of ordinary skill in the art. Optionally, the substrate is rinsed with water.

Preferably an acid or alkaline conditioner is applied to the substrate prior to application of the catalyst, aqueous reducing solution containing the anti-passivation compound or the rinse consisting of water and the anti-passivation compound and electroless copper plating. Conventional conditioners can be used. Such conditioners can include one or more cationic surfactants, non-ionic surfactants, complexing agents and pH adjusters or buffers well known to those of ordinary skill in the art. Examples of commercially available acid conditioners are CIRCUPOSIT™ Conditioners 3320A and 3327 solutions (available from DuPont™). Examples of commercially available alkaline conditioners include, but are not limited to, aqueous alkaline surfactant solutions containing one or more quaternary amines and polyamines. Examples of commercially available alkaline conditioners are CIRCUPOSIT™ Conditioner 231, 3325, 813, 860 and 8512 solutions (available from DuPont™). Conditioners are applied according to conventional parameters and amounts well known to those of ordinary skill in the art. Optionally, the substrate is rinsed with water.

Optionally, conditioning can be followed by micro-etching. Conventional micro-etching compositions can be used. Micro-etching is designed to provide a clean micro-roughened metal surface on exposed metal (e.g. inner layers and surface etch) to enhance subsequent adhesion of plated electroless copper and later electroplate. Micro-etches include, but are not limited to, 50 g/L to 120 g/L sodium persulfate or sodium or potassium oxymonopersulfate and sulfuric acid (1-2%) mixture, or generic sulfuric acid/hydrogen peroxide. Examples of commercially available micro-etching compositions are CIRCUPOSIT™ Microetch 3330 Etch solution and PREPOSIT™ 748 Etch solution (both available from DuPont™). Micro-etches are applied under conventional parameters well known to those of ordinary skill in the art. Optionally, the substrate is rinsed with water.

Optionally, a pre-dip can then be applied to the micro-etched substrate and through-holes. Examples of pre-dips include, but are not limited to, organic salts such as potassium sodium tartrate tetrahydrate or sodium citrate, 0.5% to 3% sulfuric acid or nitric acid, or an acidic solution of 25 g/L to 75 g/L sodium chloride. A commercially available pre-dip is CIRCUPOSIT™ 6520A acid solution (available from DuPont™). Pre-dips are applied under conventional parameters and in amounts well known to those of ordinary skill in the art.

A catalyst is then applied to the substrate. Preferably, the catalyst is an ionic catalyst. While it is envisioned that any conventional catalyst suitable for electroless metal plating which includes a catalytic metal can be used, preferably, a palladium catalyst is used in the methods of the present invention. An example of a commercially available palladium ionic catalyst is CIRCUPOSIT™ 6530 Catalyst. The catalyst can be applied by immersing the substrate in a solution of the catalyst, or by spraying the catalyst solution on the substrate, or by atomization of the catalyst solution on the substrate using conventional apparatus. The catalysts can be applied at temperatures from room temperature to about 80° C, preferably, from about 30° C to about 60° C. The substrate and features are optionally rinsed with water after application of the catalyst.

Following application of the catalyst to the substrate, an aqueous reducing solution, preferably, including one or more anti-passivation compounds described above, and one or more conventional reducing agents is applied to the catalyzed substrate. One or more anti-passivation compounds can be included in the aqueous reducing solution, preferably, in amounts of 0.1 mg/L to 100 mg/L, more preferably, from 0.5 mg/L to 50 mg/L, further preferably, from 0.5 mg/L to 10 mg/L. Conventional compounds known to reduce metal ions to metal can be used to reduce the metal ions of the catalysts to their metallic state. Such reducing agents are described above. Reducing agents are included in amounts to reduce substantially all the metal ions to metal, such as Pd(II) to Pd°. Preferably, reducing agents are included in amounts of 0.1 g/L to 100 g/L, more preferably, from 0.1 g/L to 60 g/L, even more preferably, from 0.1 g/L to 10 g/L, further preferably, from 0.1 g/L to 5 g/L, most preferably, from 0.1 g/L to 2 g/L.

Optionally, but preferably, the catalyzed substrate is then rinsed with water. The aqueous rinse can consist of one or more anti-passivation compounds in addition to water, or the rinse can consist of water. When one or more anti-passivation compounds are included in the water rinse, preferably, the compounds are included in amounts of 0.1 mg/L to 100 mg/L, more preferably, from 0.5 mg/L to 50 mg/L, further preferably, from 0.5 mg/L to 10 mg/L.

The substrate and walls of the through-holes or vias are then plated with copper using an electroless copper plating composition of the present invention. Methods of electroless copper plating of the present invention can be done at temperatures from room temperature to about 50 °C. Preferably, methods of electroless copper plating of the present invention are done at temperatures from room temperature to about 45 °C, more preferably, electroless copper plating is done from room temperature to about 40 °C. The substrate can be immersed in the electroless copper plating composition of the present invention or the electroless copper plating composition can be sprayed on the substrate. Methods of electroless copper plating are done in an alkaline environment of pH greater than 7. Preferably, methods of electroless copper plating of the present invention are done at a pH of 8 to 14, even more preferably, from 10 to 14.

The electroless copper plating compositions of the present invention include, preferably consist of, one or more sources of copper ions; one or more stabilizers; one or more complexing or chelating agents; one or more reducing agents; water; and, optionally, one or more surfactants, and; optionally, one or more pH adjusting agents; and any corresponding cations or anions of the foregoing components; wherein a pH of the electroless copper plating composition is greater than 7.

Sources of copper ions and counter anions include, but are not limited to, water soluble halides, nitrates, acetates, sulfates and other organic and inorganic salts of copper. Mixtures of one or more of such copper salts can be used to provide copper ions. Examples are copper sulfate, such as copper sulfate pentahydrate, copper chloride, copper nitrate, copper hydroxide and copper sulfamate. Preferably, the one or more sources of copper ions of the electroless copper plating composition of the present invention range from 0.5 g/L to 30 g/L, more preferably, from 1 g/L to 25 g/L, even more preferably, from 5 g/L to 20 g/L, further preferably, from 5 g/L to 15 g/L, and, most preferably, from 8 g/L to 15 g/L.

Stabilizers include, but are not limited to, sulfurous compounds such as s-carboxymethyl-L-cysteine, thiodiglycolic acid, thiosuccinic acid, 2,2'-Dithiodisuccinic acid, mercaptopyridine, mercaptobenzothiazole, thiourea; compounds such as pyridine, purine, quinoline, indole, indazole, imidazole, pyrazine or their derivatives; alcohols such as alkyne alcohols, allyl alcohols, aryl alcohols or cyclic phenols; hydroxy substituted aromatic compounds such as methyl-3,4,5-trihydroxybenzoate, 2,5-dihydroxy-1,4-benzo quinone or 2,6-dihydroxynaphthalene; carboxylic acids, such as citric acid, tartaric acid, succinic acid, malic acid, malonic acid, lactic acid, acetic acid or salts thereof; amines; amino acids; aqueous soluble metal compounds such as metal chlorides and sulfates; silicon compounds such as silanes, siloxanes or low to intermediate molecular weight polysiloxanes; germanium or its oxides or hydrides; cyanide and ferricyanide compounds, or polyalkylene glycols, cellulose compounds, alkylphenyl ethoxylates or polyoxyethylene compounds; or stabilizers such as pyridazine, methylpiperidine, 1,2-di (2-pyridyl)ethylene, 1,2-di-(pyridyl)ethylene, 2,2'-dipyridy lamine, 2,2'-bipyridyl, 2,2'-bipyrimidine, 6,6'-dimethyl-2,2'- dipyridyl, di-2-pyrylketone, N,N,N',N'-tetraethylenediamine, naphthalene, 1.8-naphthyridine, 1.6- naphthyridine, tetrathiafurvalene, terpyridine, pththalic acid, isopththalic acid or 2,2'-dibenzoic acid. Preferably, the stabilizers are s-carboxymethyl-L-cysteine, thiodiglycolic acid, thiosuccinic acid, 2,2'-dithiosuccinic acid, mercaptopyridine, mercaptobenzothiazole, 2,2'-bipyridyl or mixtures thereof, more preferably, the stabilizers are s-carboxymethyl-L-cysteine, 2,2'-dithiosuccinic acid, mercaptobenzothiazole, 2,2'-bipyridyl or mixtures thereof. Such stabilizers can be included in the electroless copper plating compositions in amounts of 0.5 ppm or greater, preferably, from 0.5 ppm to 200 ppm, further preferably, from 1 ppm to 50 ppm.

Complexing or chelating agents include, but are not limited to, potassium sodium tartrate tetrahydrate, sodium tartrate, sodium salicylate, sodium salts of ethylenediamine tetraacetic acid (EDTA), nitriloacetic acid or its alkali metal salts, gluconic acid, gluconates, triethanolamine, modified ethylene diamine tetraacetic acids, S,S-ethylene diamine disuccinic acid, hydantoin or hydantoin derivatives. Hydantoin derivatives include, but are not limited to, 1-methylhydantoin, 1,3-dimethylhydantoin or 5,5-dimethylhydantoin. Preferably, the complexing agents are chosen from one or more of potassium sodium tartrate tetrahydrate, sodium tartrate, nitriloacetic acid or its alkali metal salts, such as sodium and potassium salts of nitirloacetic acid, haydantoin or hydantoin derivatives. Preferably, EDTA and its salts are excluded from the electroless copper plating compositions of the present invention. More preferably, the complexing agents are chosen from potassium sodium tartrate tetrahydrate, sodium tartrate, nitriloacetic acid, nitriloacetic acid sodium salt, or hydantoin derivates. Even more preferably, the complexing agents are chosen from potassium sodium tartrate tetrahydrate, sodium tartrate, 1-methylhydantoin, 1,3-dimethylhydantoin or 5,5-dimethylhydantoin. Further preferably, the complexing agents are chosen from potassium sodium tartrate tetrahydrate or sodium tartrate. Most preferably, the complexing agent is potassium sodium tartrate tetrahydrate.

Complexing agents are included in the electroless copper plating compositions of the present invention in amounts of 10 g/l to 150 g/L, preferably, from 20 g/L to 150 g/L, more preferably, from 30 g/L to 100 g/L.

Reducing agents in the electroless copper compositions include, but are not limited to, formaldehyde, formaldehyde precursors, formaldehyde derivatives, such as paraformaldehyde, borohydrides, such sodium borohydride, substituted borohydrides, boranes, such as dimethylamine borane (DMAB), saccharides, such as grape sugar (glucose), glucose, sorbitol, cellulose, cane sugar, mannitol or gluconolactone, hypophosphite or salts thereof, such as sodium hypophosphite, hydroquinone, catechol, resorcinol, quinol, pyrogallol, hydroxyquinol, phloroglucinol, guaiacol, gallic acid, 3,4-dihydroxybenzoic acid, phenolsulfonic acid, cresolsulfonic acid, hydroquinonsulfonic acid, ceatecholsulfonic acid, tiron or salts of all of the foregoing reducing agents. Preferably, the reducing agents are chosen from formaldehyde, formaldehyde derivatives, formaldehyde precursors, borohydrides or hypophosphite or salts thereof, hydroquinone, catechol, resorcinol, or gallic acid. More preferably, the reducing agents are chosen from formaldehyde, formaldehyde derivatives, formaldehyde precursors, or sodium hypophosphite. Most preferably, the reducing agent is formaldehyde.

Reducing agents are included in the electroless copper plating compositions in amounts of 1 g/L to 10 g/L.

Optionally, one or more pH adjusting agents can be included in the electroless copper plating compositions to adjust the pH to an alkaline pH. Acids and bases can be used to adjust the pH, including organic and inorganic acids and bases. Preferably, inorganic acids or inorganic bases, or mixtures thereof are used to adjust the pH of the electroless copper plating compositions. Inorganic acids suitable for use of adjusting the pH of the electroless copper plating compositions include, for example, phosphoric acid, nitric acid, sulfuric acid or hydrochloric acid. Inorganic bases suitable for use of adjusting the pH of the electroless copper plating compositions include, for example, ammonium hydroxide, sodium hydroxide or potassium hydroxide. Preferably, sodium hydroxide, potassium hydroxide or mixtures thereof are used to adjust the pH of the electroless copper plating compositions, most preferably, sodium hydroxide is used to adjust the pH of the electroless copper plating compositions.

Optionally, one or more surfactants can be included in the electroless copper plating compositions of the present invention. Such surfactants include ionic, such as cationic and anionic surfactants, non-ionic and amphoteric surfactants. Mixtures of the surfactants can be used. Surfactants can be included in the compositions in amounts of 0.001 g/L to 50 g/L, preferably, in amounts of 0.01 g/L to 50 g/L.

Cationic surfactants include, but are not limited to, tetra-alkylammonium halides, alkyltrimethylammonium halides, hydroxyethyl alkyl imidazoline, alkylbenzalkonium halides, alkylamine acetates, alkylamine oleates and alkylaminoethyl glycine.

Anionic surfactants include, but are not limited to, alkylbenzenesulfonates, alkyl or alkoxy naphthalene sulfonates, alkyldiphenyl ether sulfonates, alkyl ether sulfonates, alkylsulfuric esters, polyoxyethylene alkyl ether sulfuric esters, polyoxyethylene alkyl phenol ether sulfuric esters, higher alcohol phosphoric monoesters, polyoxyalkylene alkyl ether phosphoric acids (phosphates) and alkyl sulfosuccinates.

Amphoteric surfactants include, but are not limited to, 2-alkyl-N-carboxymethyl or ethyl-N-hydroxyethyl or methyl imidazolium betaines, 2-alkyl-N-carboxymethyl or ethyl-N-carboxymethyloxyethyl imidazolium betaines, dimethylalkyl betains, N-alkyl-β-aminopropionic acids or salts thereof and fatty acid amidopropyl dimethylaminoacetic acid betaines.

Preferably, the surfactants are non-ionic. Non-ionic surfactants include, but are not limited to, alkyl phenoxy polyethoxyethanols, polyoxyethylene polymers having from 20 to 150 repeating units and random and block copolymers of polyoxyethylene and polyoxypropylene.

The following examples are not intended to limit the scope of the invention but to further illustrate the invention.

### Examples 1-16 (Invention)

### Anti-Passivation of Copper

The effect of anti-passivation additives on copper surfaces of copper clad laminates (CCL) as they were processed through a tartaric-based electroless copper plating bath was evaluated by processing 200 µm thick copper clad laminates free of drilled features through the process flow disclosed below. Reducer baths with the anti-passivation additives ranging at concentration of 0.5 mg/L, 2 mg/L and 5 mg/L were compared to results obtained with a control (Example 1) which excluded an anti-passivation additive in the reducer bath. Electroless copper plating initiation was not observed in the absence of an anti-passivation additive under the specified conditions.
1. Each CCL was treated with 20 Vol.% CIRCUPOSIT™ Conditioner 8512 alkaline conditioner solution for 1.5 min at about 45° C;
2. Each CCL was then rinsed with tap water for 30 sec at room temperature;
3. Each CCL was then treated with CIRCUPOSIT™ 6520A pre-dip solution at pH =2 at about 28° C for 30 sec;
4. Each CCL was then immersed into 20 Vol.% CIRCUPOSIT™ 6530 Catalyst which is an ionic aqueous alkaline palladium catalyst concentrate (available from DuPont) for 60 sec at about 50 °C, wherein the catalyst is buffered with sufficient amounts of sodium carbonate, sodium hydroxide or nitric acid to achieve a catalyst pH of 9-9.5;
5. Each CCL was then rinsed with tap water for 30 sec at room temperature;
6. Each CCL was then immersed into an aqueous solution of 0.6 g/L dimethylamine borane, 5 g/L boric acid at a pH range of 7-7.5 and one of the anti-passivation additives shown in Table 1 at concentrations shown in Table 1 at about 34° C for 1 min to reduce the palladium ions to palladium metal and simultaneously passivate the copper of each CCL;
7. Each CCL was then rinsed with tap water for 30 sec; and
8. Each CCL was then immersed in the alkaline electroless copper plating bath of Table 2 and copper plated at about 34 °C, for 5 min.

**Table 1**

| **Examples** | **Anti- Passivation Compound** | **Anti- Passivation Compound Structure** | **Concentration (mg/L)** |
|---|---|---|---|
| 1 | none | none | 0 |
| 2-4 | 2,2'-bis(4,5-dimethylimidazole) | 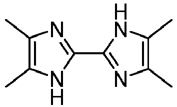 | 0.5, 2, 5 |
| 5-7 | 2-guanidobenzimidazole | 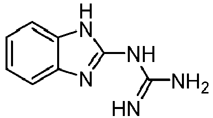 | 0.5, 2, 5 |
| 8-9 | 2-(aminoethyl)-benzimidazole dihydrochloride | 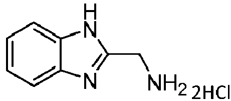 | 0.5, 2 |
| 10-11 | 1-(3-aminopropyl) imidazole | 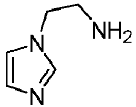 | 0.5, 2 |
| 12 | 2-(1-naphthylmethyl) imidazoline hydrochloride | 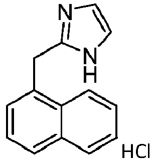 | 2 |
| 13 | 2-(2-aminophenyl)-IH-benzimidazole | 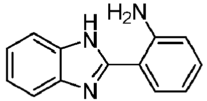 | 2 |
| 14 | 2-(2-hydoxyphenyl)-1H-benzimidazole | 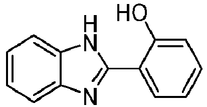 | 2 |
| 15 | Benzotriazole-5-carboxylic acid | 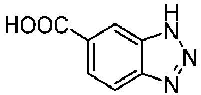 | 2 |
| 16 | | 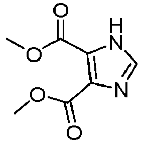 | 2 |

**Table 2**

| **Electroless Copper Plating Bath** | |
|---|---|
| **Component** | **Amount** |
| Copper sulfate pentahydrate | 9.6 g/L |
| Rochelle salts | 35 g/L |
| Sodium hydroxide | 8 g/L |
| Formaldehyde | 4 g/L |
| S-carboxymethylcysteine | 7.5 mg/L |
| Quadrol¹ | 100 mg/L |

| | |
|---|---|
| ¹N,N,N',N'-tetrakis(2-hydroxypropyl)ethylenediamine (available from Sigma-Aldrich) | |

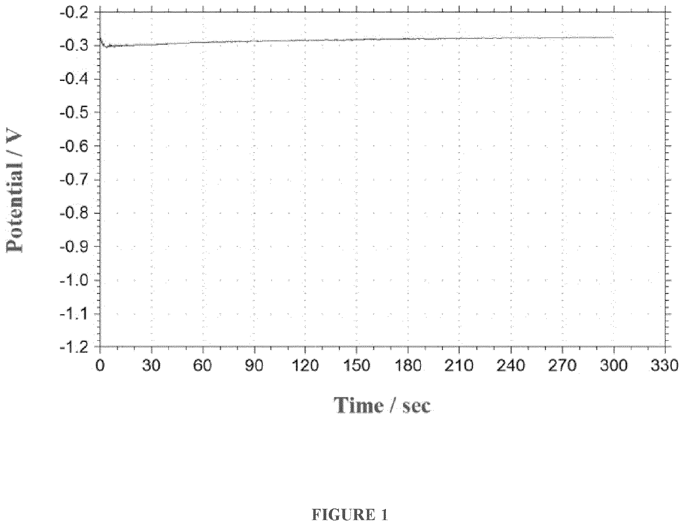

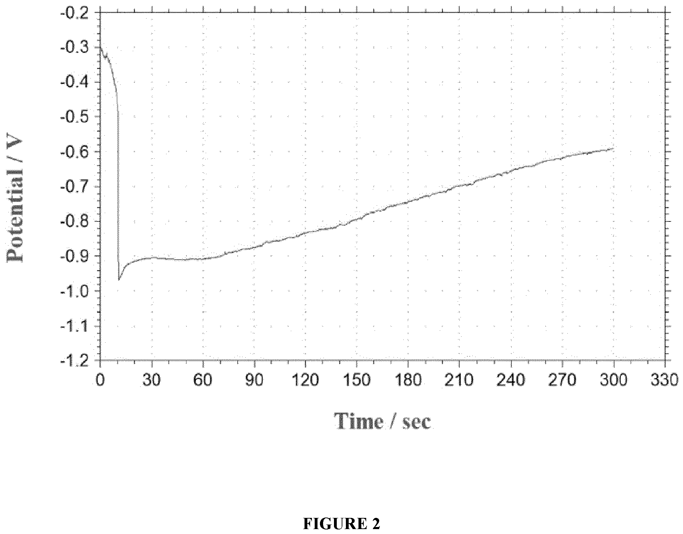

Two electrochemical measurements were performed on each CCL. Electrochemical measurements were performed on a CHInstruments 760e potentiostat with a 200 mL bath volume maintained at 34°C with a re-circulating chiller. The first measurement, an open circuit potential measurement, was performed while the laminate was submerged in the electroless copper bath using a two-electrode configuration with a Ag/AgCl reference electrode. Care was taken during the open-circuit potential measurements to not submerge the clips used to hold samples. The open-circuit potential curves could be categorized into two groups: samples that exhibited no abrupt shift in the open-circuit potential to more cathodic potentials (no electroless initiation) as shown in **Figure 1** for the control of Example 1, and samples that exhibited an abrupt shift in the open-circuit potentials to more cathodic potentials (electroless initiation) as shown in **Figure 2****.** While **Figure 2** is the open-circuit potential curve for Example 6, the open-circuit potential curves for Examples 2-5 and 7-16 were substantially the same. As a control, no electroless initiation was observed by the open-circuit potential measurement in the absence of an anti-passivation additive as shown in **Figure 1****.** The CCL treated with the reducing solutions which included the anti-passivation compounds had smooth bright copper deposits. In contrast, the CCL treated with the reducing solution without an anti-passivation compound had a rough and dark copper deposit.

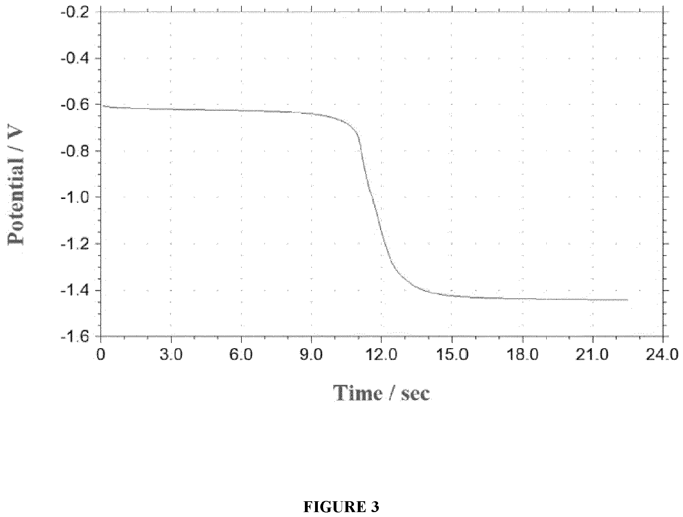

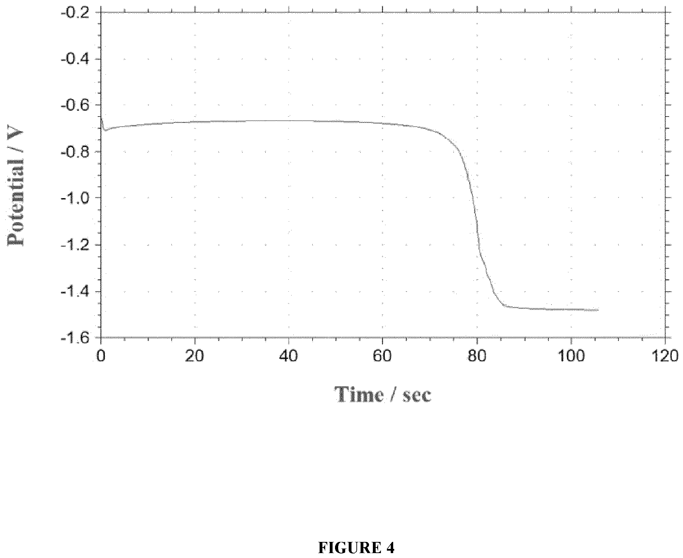

Following the open-circuit potential measurement the relative quantity of oxide was compared between samples for a 2.54x5.08 cm CCL area that had been fully submerged in the electroless copper bath. The longer time to reduce the oxide was equivalent to more oxide. The degree of oxidation on the surface of the removed piece was assessed visually, and by chronopotentiometry measured while submerging the CCL sample in a 6M KOH / 1M LiOH electrolyte and applying a small cathodic current of 5 mA using a three-electrode configuration with a Ti-rod counter electrode and a Ag/AgCl reference. The potential was monitored during the chronopotentiometry measurement, and when the potential shifted to the hydrogen evolution potential (ca. -1.4V) the reduction of oxides on the CCL surface was considered complete. CCL with insignificant amounts of oxide to reduce had complete reduction in about 10 sec as shown in **Figure 3****,** for Example 6; however, Examples 2-5 and 7-16 had substantially the same chronopotentiometry graphs. CCL with more oxidation took upwards of 10 times as long to achieve complete reduction of surface oxidation as shown in **Figure 4** for control Example 1.

### Examples 17-34 (Comparatives)

### Passivation of Copper

The procedure and formulations disclosed above in Examples 1-16 were repeated except the additives included in the reducer baths and the amounts of the additives were those disclosed in Table 3.

**Table 3**

| **Examples** | **Additive Compound** | **Additive Compound Structure** | **Concentration (mg/L)** |
|---|---|---|---|
| 17-18 | 1-(2-aminophenyl)-1H-pyrazole | 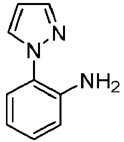 | 0.5, 2 |
| 19-20 | 1-(3-aminopropyl)-2-methyl-1H-imidazole | 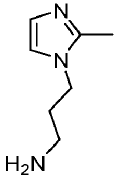 | 0.5, 2 |
| 21-22 | 1,2,4-triazole-3-carboxylic acid | 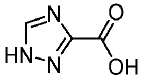 | 0.5, 2 |
| 23-24 | 1,2,4-triazolo(1,5-a)pyrimidine | 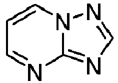 | 0.5, 2 |
| 25-26 | 1H-benzotraizole-4-sulfonic acid | 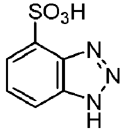 | 0.5, 2 |
| 27-28 | 1H-tetrazole-5-acetic acid | 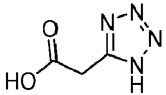 | 0.5, 2 |
| 29-30 | 2-(methylthio) benzimidazole | 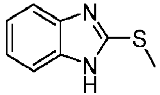 | 0.5, 2 |
| 31-32 | 2-phenylimidazole | 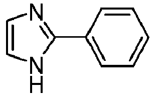 | 0.5, 2 |
| 33-34 | 4-(imidazole-1yl) phenol | 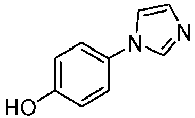 | 0.5, 2 |

Electrochemical measurements for each CCL were performed on a CHInstruments 760e potentiostat with a 200 mL bath volume maintained at 34°C with a re-circulating chiller. The open circuit potential measurement was performed while the laminate was submerged in the electroless copper bath using a two-electrode configuration with a Ag/AgCl reference electrode. Care was taken during the open-circuit potential measurements to not submerge the clips used to hold samples. The open-circuit potential curves for all the samples exhibited no abrupt shift in the open-circuit potential to more cathodic potentials (no electroless initiation). The open-circuit potential curves were substantially the same as shown in **Figure 1** for the control of Example 1.

## Claims

1. A method of electroless copper plating comprising:
a) providing a substrate comprising copper;
b) applying a catalyst to the copper of the substrate;
c) treating the catalyzed copper of the substrate with an aqueous composition comprising an imidazole compound, wherein the imidazole compound has the formula: 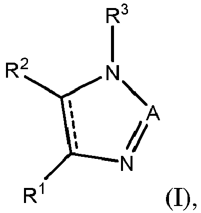 wherein R¹ and R² are independently chosen from hydrogen, (C₁-C₄)alkyl and an ester group or the carbons of R¹ and R² can be taken together to form a substituted or unsubstituted fused six membered carbon aromatic ring, wherein the substituent groups on the six membered carbon aromatic ring are selected from the group consisting of carboxyl, carboxy(C₁-C₄)alky, hydroxyl, hydroxy(C₁-C₄)alkyl, amino and amino(C₁-C₄)alkyl, R³ is hydrogen, hydroxyl, hydroxy(C₁-C₄)alkyl, amino or amino(C₁-C₄)alkyl, and A can be a nitrogen atom or a carbon atom, wherein when A is a carbon atom, the carbon atom can have a substituent group selected from the group consisting of substituted or unsubstituted imidazole, guanidino, substituted phenyl, and amino(C₁-C₄)alkyl;
d) applying an electroless copper plating bath to the treated copper of the substrate; and
e) electroless plating copper on the treated copper of the substrate with the electroless copper plating bath.

2. A method of electroless copper plating comprising:
a) providing a substrate comprising copper;
b) applying a catalyst to the copper of the substrate;
c) treating the catalyzed copper of the substrate with an aqueous composition comprising a reducing agent and an imidazole compound, wherein the imidazole compound has the formula: 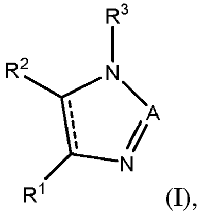 wherein R¹ and R² are independently chosen from hydrogen, (C₁-C₄)alkyl and an ester group or the carbons of R¹ and R² can be taken together to form a substituted or unsubstituted fused six membered carbon aromatic ring, wherein the substituent groups on the six membered carbon aromatic ring are selected from the group consisting of carboxyl, carboxy(C₁-C₄)alky, hydroxyl, hydroxy(C₁-C₄)alkyl, amino and amino(C₁-C₄)alkyl, R³ is hydrogen, hydroxyl, hydroxy(C₁-C₄)alkyl, amino or amino(C₁-C₄)alkyl, and A can be a nitrogen atom or a carbon atom, wherein when A is a carbon atom, the carbon atom can have a substituent group selected from the group consisting of substituted or unsubstituted imidazole, guanidino, substituted phenyl, and amino(C₁-C₄)alkyl;
d) applying an electroless copper plating bath to the treated copper of the substrate; and
e) electroless plating copper on the treated copper of the substrate with the electroless copper plating bath.

3. The method of claim 2, further comprising applying a conditioner to the substrate comprising the copper prior to applying the catalyst.

4. The method of claim 2, further comprising rinsing the substrate with the catalyzed copper after the treatment with the aqueous composition comprising the reducing agent and the imidazole compound with a water rinse solution.

5. The method of claim 4, wherein the water rinse solution comprises an imidazole compound having the formula: 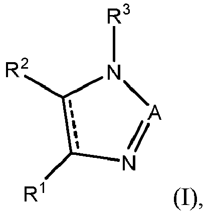 wherein R¹ and R² are independently chosen from hydrogen, (C₁-C₄)alkyl and an ester group or the carbons of R¹ and R² can be taken together to form a substituted or unsubstituted fused six membered carbon aromatic ring, wherein the substituent groups on the six membered carbon aromatic ring are selected from the group consisting of carboxyl, carboxy(C₁-C₄)alky, hydroxyl, hydroxy(C₁-C₄)alkyl, amino and amino(C₁-C₄)alkyl, R³ is hydrogen, hydroxyl, hydroxy(C₁-C₄)alkyl, amino or amino(C₁-C₄)alkyl, and A can be a nitrogen atom or a carbon atom, wherein when A is a carbon atom, the carbon atom can have a substituent group selected from the group consisting of substituted or unsubstituted imidazole, guanidino, substituted phenyl, and amino(C₁-C₄)alkyl.

6. The method of electroless copper plating of claim 2, wherein the imidazole compound is at concentrations of 0.1 mg/L to 100 mg/L.

7. The method of electroless copper plating of claim 2, wherein the aqueous composition further comprises one or more acids.

8. The method of electroless copper plating of claim 2, wherein the imidazole compound has the formula: 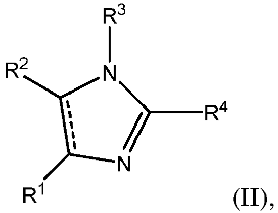 wherein R¹ and R² are independently hydrogen, (C₁-C₃)alkyl, and an ester group, or R¹ and R² are taken together with all of their carbon atoms to form a substituted or unsubstituted six membered carbon aromatic fused ring, wherein the substituent groups on the six membered carbon aromatic fused ring are selected from the group consisting of carboxyl, carboxy(C₁-C₃)alky, hydroxyl, hydroxy(C₁-C₃)alkyl, amino and amino(C₁-C₃)alkyl, R³ is hydrogen or amino(C₁-C₂)alkyl, and R⁴ is selected from the group consisting of substituted or unsubstituted imidazole, guanidino, substituted phenyl, amino(C₁-C₄)alkyl, and naphthyl(C₁-C₄)alkyl, wherein the substituent groups on the phenyl are selected from the group consisting of hydroxyl and amino and the substituent groups on the imidazole are selected from the group consisting of (C₁-C₃)alkyl, hydroxyl(C₁-C₃)alkyl and amino(C₁-C₃)alkyl.

9. The electroless copper plating method of claim 8, wherein the imidazole compounds are selected from the group consisting of 2,2'-bis(4,5-dimethylimidazole), 2-guanidobenzimidazole, 2-(aminomethyl)benzimidazole dihydrochloride, 2-(2-aminophenyl)-1H-benimidazole, 2-(2-hydroxyphenyl)-1H-benzimidazole and mixtures thereof.
